# EUROPEAN PATENT APPLICATION

(11) **EP 2 804 371 A1**
(43) Date of publication of application: **19.11.2014**
(21) Application number: 12864948.0
(22) Date of filing: 12.01.2012
(51) Int. Cl.: H04N 5/64, G09F 9/00

(54) **DISPLAY DEVICE**

(71) Applicant: Panasonic Corporation, Kadoma-shi, Osaka 571-8501 (JP)
(72) Inventor: SAKURAI, Kazuho, Osaka 540-6207 (JP); MIZUNO, Toshiya, Osaka 640-6207 (JP); KINUGAWA, Isshin, Osaka 540-6207 (JP)
(74) Representative: Grünecker, Kinkeldey, Stockmair & Schwanhäusser
(86) International application number: PCT/JP2012/000143
(87) International publication number: WO 2013/105134

(57) **Abstract**

A display system in which no space for housing an external terminal device is created on a board is provided. This display device includes: a display panel; a board; a back cover which covers the board at least partially and which has an opening; and a slot structure which is arranged inside the opening and into which an external terminal device is inserted. The slot structure includes a guide which holds the external terminal device inserted so that the external terminal device defines a predetermined angle with respect to the board and a terminal which electrically connects the external terminal device to the board.

## Description

### TECHNICAL FIELD

The present invention relates to a display device to which an external terminal device is attached, and more particularly relates to a mechanism for a display device to which an external terminal device is attached.

### BACKGROUND ART

Some of conventional display devices can have their functions extended by connecting an external terminal device thereto. Examples of such external terminal devices to be connected to display devices include cards with an IC to decode an encrypted broadcast signal, storage media, and communications modules.

For example, Patent Document No. 1 discloses a display device which has an internal board with a slot through which an external terminal device can be inserted.

### CITATION LIST

### PATENT LITERATURE

Patent Document No. 1: Japanese Laid-Open Patent Publication No. 2007-250926

### SUMMARY OF INVENTION

### TECHNICAL PROBLEM

According to the conventional technologies, however, either such a slot through which an external terminal device is inserted or the external terminal device itself will take up so much space on the board that it is difficult to design the display device easily or cut down the cost, which is a problem.

More specifically, according to the conventional technologies, most of the external terminal device is supposed to be housed in the display device, and therefor, a space (such as a slot) for housing the external terminal device should be secured on the board of the display device.

Basically, however, it is the user to decide whether or not he or she would like to use an external terminal device. That is why even if such a space for housing an external terminal device is created on the board, no external terminal devices could be used at all in some cases. In such a situation, the space created on the board for external terminal devices would be useless. Therefore, if such a space which has been created on the board for external terminal devices could be eliminated, then the design process would be done more easily and the cost could be cut down.

The present inventors perfected our invention in order to overcome such a problem by providing a display system in which no such space for housing an external terminal device is created on the board of a display device.

### SOLUTION TO PROBLEM

A display device according to an embodiment of the present invention includes: a display panel; a board; a back cover which covers the board at least partially and which has an opening; and a slot structure which is arranged inside the opening and into which an external terminal device is inserted. The slot structure includes a guide which holds the external terminal device inserted so that the external terminal device defines a predetermined angle with respect to the board and a terminal which electrically connects the external terminal device to the board.

The guide may regulate the angle of insertion of the external terminal device so that the external terminal device is inserted at the predetermined angle with respect to the board.

If the guide has a length of 40 mm or more, the guide may hold the external terminal device so that the external terminal device defines an angle of 5 to 9 degrees with respect to the board.

The bottom surface of the slot structure may partially cover the board.

The slot structure may have a box shape which is formed by the bottom surface of the slot structure and side surfaces that cover the slot structure entirely except an insertion slot into which the external terminal device is inserted.

The slot structure may cover the periphery of the opening at least partially.

The slot structure may be comprised of a plurality of members including a first member with the terminal and a second member with the guide.

The second member may have connecting portions for mounting the second member onto the board.

An end of the connecting portions may be made of an elastically deformable material, and the second member may be mounted onto the board by elastically deforming the respective ends of the connecting portions and fitting the ends into holes or notches that have been cut through the board.

The back cover may have a first plane and a second plane which is arranged so as to be raised with respect to the first plane. The opening may have been cut through the second plane. And when the guide holds the external terminal device, the external terminal device may be held so as to be housed within the second plane.

A terminal receiving a signal from an external device may be arranged in a step portion which is located between the first and second planes.

### ADVANTAGEOUS EFFECTS OF INVENTION

In a display device according to the present invention, the back cover of the display device has a slot to hold an external terminal device obliquely with respect to the display device. Thus, there is no need to create a space corresponding to the area of the external terminal device on the board of the display device but just a space for connecting the slot needs to be secured. Since the space that is ordinarily created for an external terminal device can be eliminated from the board, the design process can get done more easily and the cost can be cut down.

### BRIEF DESCRIPTION OF DRAWINGS

[FIG. **1A**] A front view of a display device **100.**
[FIG. **1B**] A rear view of the display device **100.**
[FIG. **1C**] A side view of the display device **100.**
[FIG. **2**] Illustrates an exemplary appearance of an external terminal device **200.**
[FIG. **3A**] A rear view of a display device **100** according to an embodiment of the present invention.
[FIG. **3B**] A perspective view illustrating how a connecting slot **103** and surrounding members look when the external terminal device **200** is inserted into the display device **100.**
[FIG. **3C**] A side view of the display device **100** into which the external terminal device **200** has been inserted.
[FIG. **4**] A cross-sectional view of the display device **100** into which the external terminal device **200** has been inserted.
[FIG. **5**] An exploded perspective view of the connecting slot **103** and other surrounding members.
[FIG. **6**] **(a)** is an enlarged perspective view of a first member **402** and **(b), (c)**, **(d)** and **(e)** are respectively a left side view, a top view, a right side view, and a bottom view of the first member **402.**
[FIG. 7] **(a)** is an enlarged perspective view of a second member **403** and **(b), (c)**, **(d)** and **(e)** are respectively a left side view, a top view, a right side view, and a bottom view of the second member **403.**

### DESCRIPTION OF EMBODIMENTS

Hereinafter, an embodiment of a display device according to the present invention will be described with reference to the accompanying drawings.

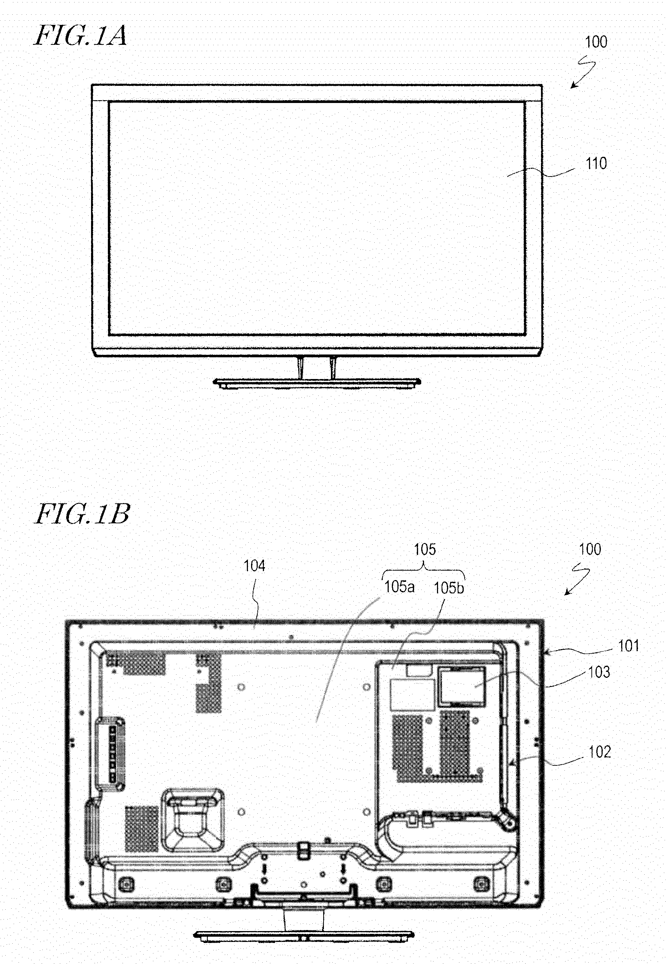

FIGS. **1A** to **1C** illustrate the appearance of a display device **100** as an embodiment of the present invention.

FIG. **1A** is a front view of the display device **100.** The display device **100** includes a display panel **110.** The display device **100** gets a video signal generated based on a broadcast signal or a storage medium in a board (not shown), which is built in the display device **100,** and displays the video signal on the display panel **110.**

FIG. **1B** is a rear view of the display device **100.** The display device **100** includes a back cover **101,** a group of terminals **102,** and a connecting slot **103.**

The back cover **101** covers not only the rear surface of the display panel **110** but also the board either entirely or partially. The back cover may be made of molded plastic or a metallic material.

The group of terminals **102** is a set of terminals which receive signals from external devices. Examples of terminals that may form the group of terminals **102** include an HDMI terminal, an SD card slot, a YUV component terminal, a CVBS terminal, a broadcast signal receiving tuner terminal, a headphone terminal that outputs an audio signal, an optical output terminal, a USB terminal that communicates bidirectionally with an externally connected device, and a LAN terminal.

The connecting slot **103** is arranged in an opening, which has been cut through the back cover **101,** in order to receive an external terminal device inserted. A (group of) terminal(s) to get electrically connected to an external terminal device is arranged at the deepest end of the connecting slot **103,** and is connected to the board of the display device **100.**

It should be noted that the term "slot" originally means a "hole" or a "space". In this description, however, the "slot" refers to a combination of a hole to which an external terminal device is inserted and a structure to hold the external terminal device. That is why the slot will be sometimes referred to herein as a "slot structure" in that sense.

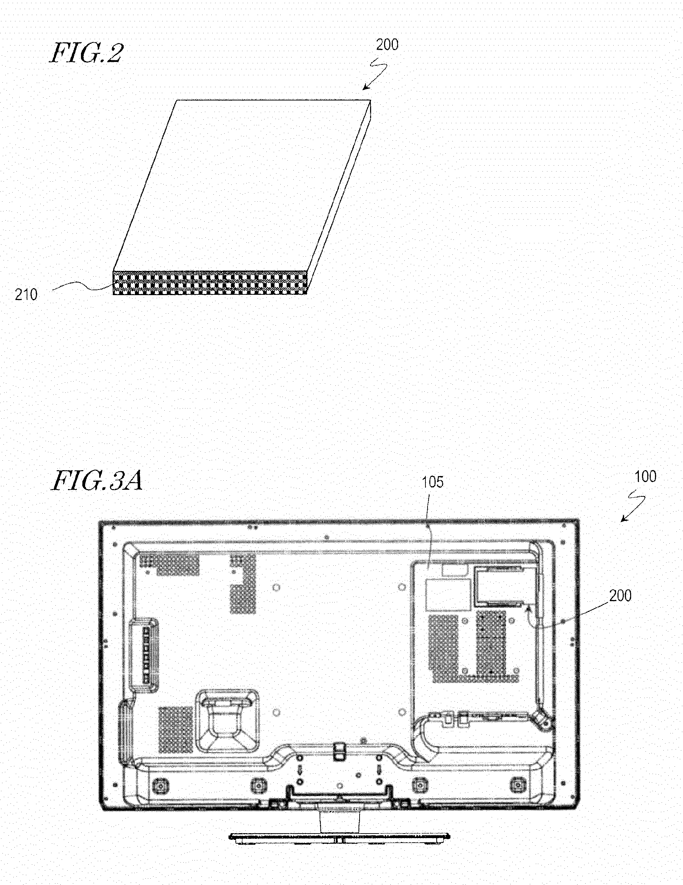

Examples of external terminal devices to be connected to the connecting slot **103** include a card compliant with the PCMCIA standard. FIG. **2** illustrates an exemplary appearance of the external terminal device **200,** which includes a group of terminals **210** to be connected to the connecting slot **103.** The group of terminals **210** is electrically conductive with internal circuits in the external terminal device **200** through wiring (not shown).

In this embodiment, the external terminal device **200** is supposed to be a CI card that needs to be used for a digital broadcast DVB-T in the European district. Examples of the circuits built in the external terminal device **200** (CI card) include an IC chip to decode an encrypted broadcast signal and a memory to store the decoded information.

It should be noted that the external terminal device **200** does not have to be a CI card. Alternatively, the external terminal device **200** may also be an IC card to descramble a scrambled signal which is attached to a CATV set top box (STB) or an IC card for use to authenticate a device which is legitimately authorized to receive a digital broadcast.

Now take a look at FIG. **1B** again.

The connecting slot **103** includes a guide to guide the external terminal device inserted to a predetermined direction and a terminal to electrically connect the external terminal device and the internal board together. The guide is also used to hold the external terminal device inserted in that position. The structure of the connecting slot **103** will be described in further detail later.

The back cover **101** has a first plane **104** and a second plane **105.** When the display panel **110** shown in FIG. **1A** is viewed straight on, the second plane **105** is located deeper (i.e., in the direction coming out of the paper) than the first plane **104.** That is to say, there is a level difference between the first and second planes **104** and **105.** It should be noted that as long as there is any plane at a different level from the first plane **104,** that plane will be referred to herein as a second plane **105.** That is why both of the planes **105a** and **105b** shown in FIG. **1B** are second planes **105.** The first and second planes **104** and **105** do not have to be planes in a strict sense.

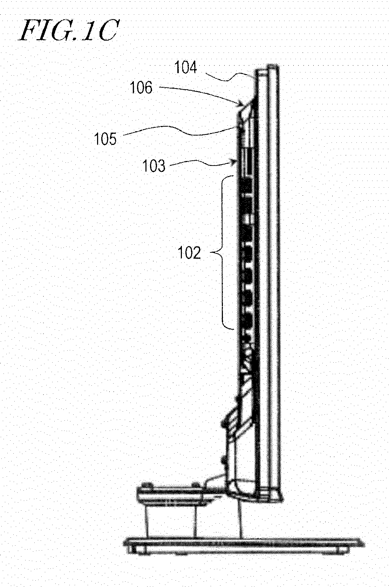

FIG. **1C** is a side view of the display device **100.** It can be seen that there is a step portion **106** between the first and second planes **104** and **105.** That is to say, the back cover **101** of this embodiment has the first and second planes **104** and **105** and a step portion **106** to create a level difference between them.

Part of the group of terminals **102** is arranged in the step portion **106.** Also, as will be described later, the connecting slot **103** is provided by taking advantage of the step portion **106.**

FIGS. **3A** to **3C** illustrate how an external terminal device has been inserted into the display device of this embodiment.

FIG. **3A** is a rear view of the display device **100** of this embodiment.

A broadcast signal that has been received by the display device **100** is decoded based on the decoding information that is stored in the external terminal device **200.**

As shown in FIG. **3A****,** in this embodiment, the external terminal device **200** inserted into the connecting slot **103** is located almost entirely within the second plane **105.** That is to say, the external terminal device **200** inserted into the connecting slot **103** does not project out of the second plane **105**. As there is no space created between the first plane **104** and the external terminal device **200,** the chances of touching the external terminal device **200** by mistake can be reduced even if the user of this display device **100** has happened to have his or her hand inserted into the space due to the presence of the step portion **106.**

In the embodiment described above, the back cover **101** is supposed to have the first and second planes **104** and **105.** However, this is just an example of the present invention. Alternatively, the back cover **101** may also have a flat surface. Even so, the connecting slot **103** may be arranged so that the external terminal device **200** is entirely located on the back cover **101.** In that case, as the external terminal device **200** will not protrude outward from the front side of the display device **100,** the chances that the user of the display device **100** will touch the external terminal device **200** by mistake can be reduced. In addition, the place to set up the display device **100** in will no longer be restricted by the external terminal device **200.** For example, if the external terminal device **200** protruded outward from the frame of the display panel **110** of this display device **100** when the display panel **110** is viewed straight on, then it would be difficult to set up the display device **100** beside the wall to which the external terminal device **200** protrudes. On the other hand, if the external terminal device **200** can be entirely arranged on the back cover **101,** then the display device **100** can be set up beside a wall in any direction. That is to say, in that case, no matter whether the external terminal device **200** has been inserted or not, there is no need for the user to change the place to set up the display device **100** in.

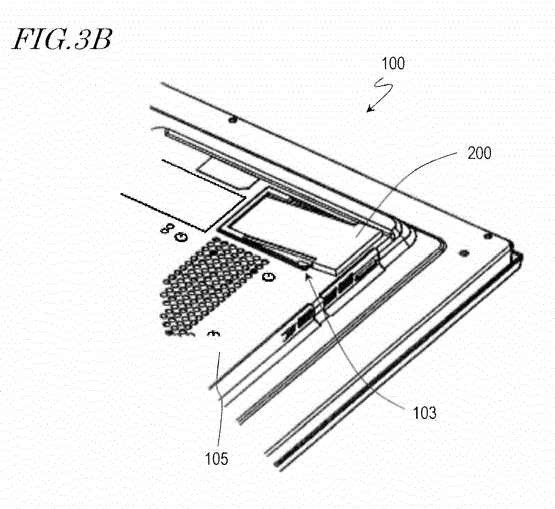

FIG. **3B** is a perspective view illustrating how the connecting slot **103** and surrounding members look when the external terminal device **200** is inserted into the display device **100. As** can be seen from FIG. **3B****,** almost all of the external terminal device **200** is housed within the second plane **105.**

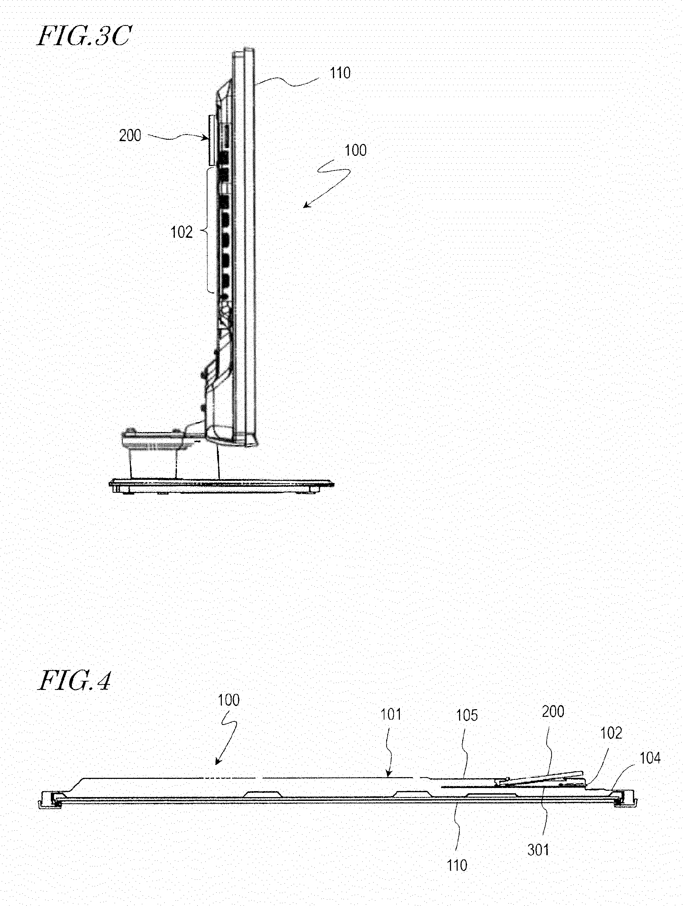

FIG. **3C** is a side view of the display device **100** into which the external terminal device **200** has been inserted. When the display panel **110** is viewed straight on, the external terminal device **200** is held at a deeper position than a part of the group of terminals **102.** Then, it is possible to prevent the external terminal device **200** from interfering with the user who is connecting a cable or anything else to the group of terminals **102.**

FIG. **4** is a cross-sectional view of the display device **100** into which the external terminal device **200** has been inserted.

The display device **100** includes a board **301** inside. The board **301** may be a printed circuit board, for example, and is covered with the back cover **101** and substantially parallel to the back cover **101.** The group of terminals **102** is arranged at one end of the board **301.**

As can be seen easily from FIGS. **3B** and **4**, the external terminal device **200** has been inserted obliquely with respect to the back cover **101.** This is because the guide of the connecting slot **103** has guided the external terminal device **200** obliquely with respect to the back cover **101** and holds the external terminal device **200** in that position.

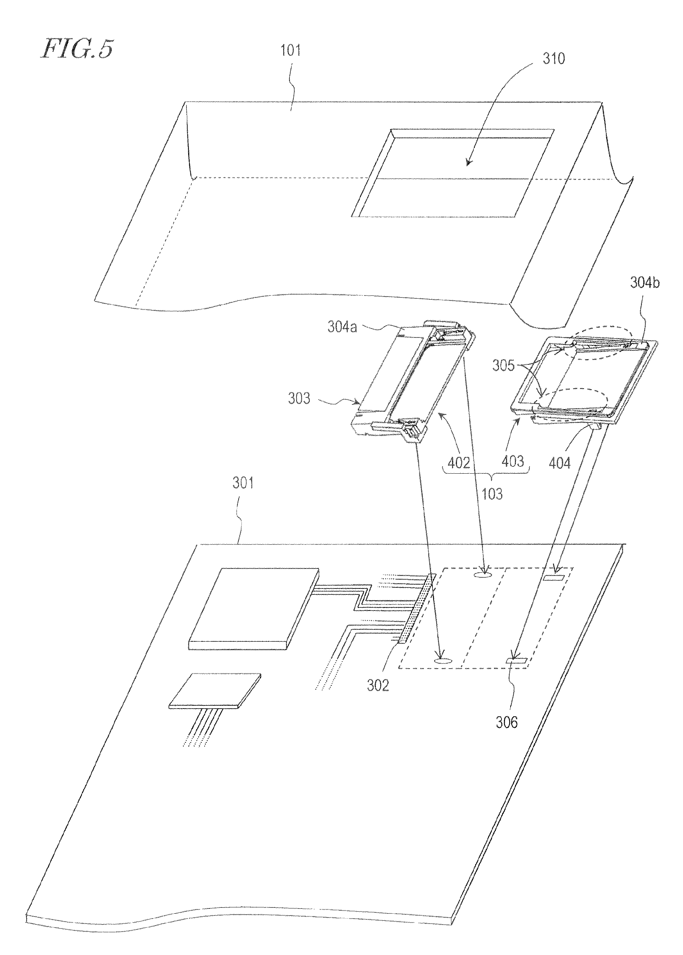

Next, it will be described in detail with reference to FIGS. **5** through **7** exactly what structure the connecting slot **103** may have to get the external terminal device **200** inserted in that way.

FIG. **5** is an exploded perspective view of the connecting slot **103** and other surrounding members. The connecting slot **103** is made up of multiple pieces including at least a first member **402** and a second member **403.**

The first member **402** includes the terminal **303** of the connecting slot **103** and a rib **304a.** One end of the terminal **303** of the connecting slot **103** is soldered with a line **302** on the board **301,** thereby mounting the first member **402** onto the board **301.** The other end of the terminal **303** will be connected to the terminal **210** (see FIG. **2**) of the external terminal device **200** when the external terminal device **200** is inserted. In this manner, the external terminal device **200** and the board **301** are electrically connected together.

The second member **403** includes a rib **304b** and a guide **305.** The second member **403** is not soldered onto the board **301.** Instead, connecting portions **404** of the second member **403** are fitted into holes **306** that have been cut through the board. In this manner, the second member **403** is mounted onto the board **301.** In this case, the second member **403** is arranged adjacent to the first member **402** on the board **301** as if these two members **402** and **403** were integrated together.

Although the first member **402** is supposed to be soldered in this example, soldering is just an exemplary means for establishing electrical connection and any other method may be used as well. Also, no matter whether the first member **402** is soldered or not, connecting portions similar to those **404** of the second member **403** may be provided for the first member **402,** too.

Furthermore, there is no need to cut the holes **306** through the board. Alternatively, an edge of the board may be notched and the connecting portions may be fitted into the notched portions.

On an area of the board **301** which is located right under the first and second members **402** and **403** mounted, circuits, chips, elements and other circuit components may be arranged. Naturally, those circuit components should be arranged so as to avoid causing an unnecessary short circuit or placing unnecessary pressure on the chips.

The guide **305** regulates the movable range of the external terminal device **200** so that the external terminal device **200** inserted into the connecting slot **103** defines a predetermined angle with respect to the board **301.** For example, the guide **305** may be configured so that when inserted into the connecting slot **103,** the external terminal device **200** defines an angle of approximately 7 degrees with respect to the board **301.**

It should be noted that this angle is only an example. In this embodiment, a card compliant with the PCMCIA standard is used as an exemplary external terminal device **200.** According to the PCMCIA standard, it is recommended that the guide to hold a terminal device have a length (i.e., a guide rail length) of 40 mm or more. On the other hand, as the angle defined by the external terminal device **200** goes closer to zero degrees, it becomes more and more difficult to create a space for mounting other circuit components on the board **301** as will be described later. For that reason, the angle suitably falls within the range of 5 to 9 degrees.

The ribs **304a** and **304b** may be made of chamfered and molded resin. The periphery of the connecting slot **103** is covered with such ribs **304a** and **304b** at least partially. As a result, the chances that the user of this display device **100** will cut his or her finger can be reduced.

After the first and second members **402** and **403** have been arranged as the connecting slot **103** on the board **301,** the board **301** is capped with the back cover **101** either entirely or just partially. The back cover **101** has an opening **310.** The connecting slot **103** is exposed through that opening **310** and is formed in a box shape. In this description, the "box shape" refers to a box that is formed by an insertion slot into which the external terminal device **200** is inserted and side surfaces which cover this connecting slot **103** entirely except the insertion slot. The box corresponds to a recess (space) which is formed by the bottom of the connecting slot **103** and at least one side surface. If the connecting slot **103** has such a box shape, the board **301** is never exposed. As a result, even if any foreign matter such as a coin has happened to enter the connecting slot **103,** the foreign matter can go deeper no than the connecting slot **103.** Consequently, the chances that the foreign matter will contact with the board **301** can be reduced.

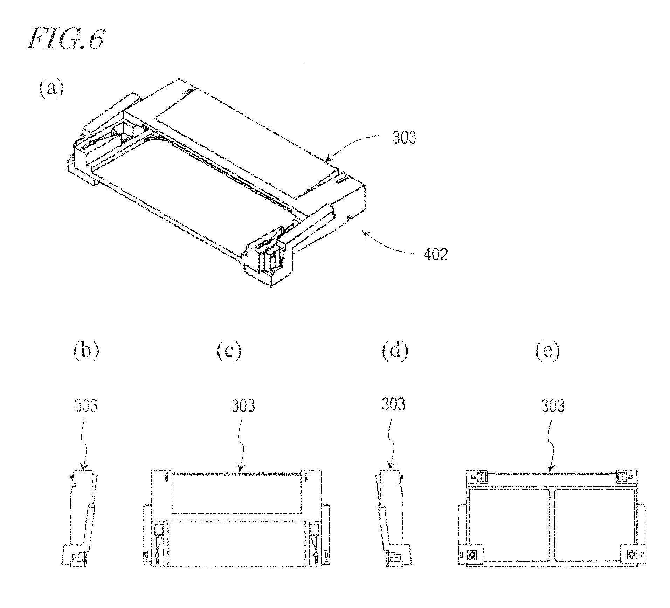

FIG. **6(a)** is an enlarged perspective view of the first member **402.** FIGS. **6(b), 6(c)**, **6(d)** and **6(e)** are respectively a left side view, a top view, a right side view, and a bottom view of the first member **402.** In all of these drawings, the position of the terminal **303** of the connecting slot **103** is indicated for your reference.

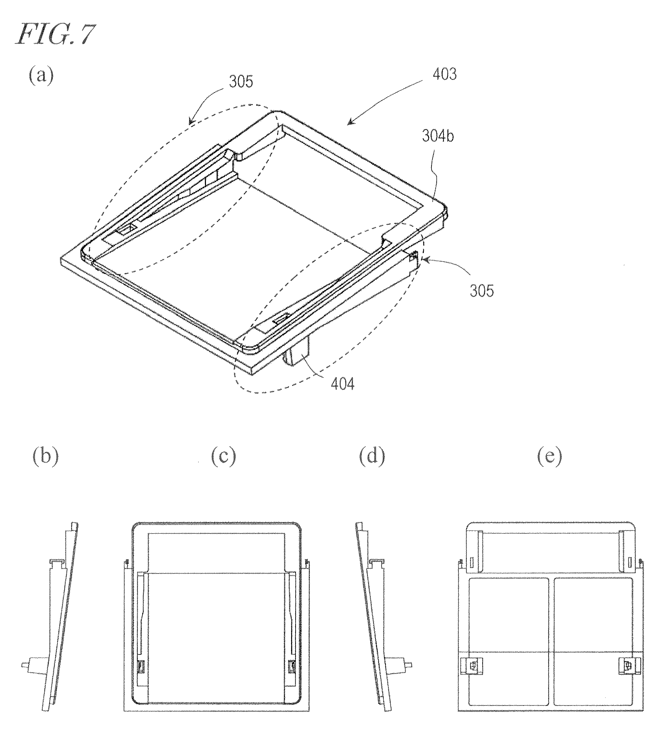

FIG. **7(a)** is an enlarged perspective view of the second member **403.** When the second member **403** is arranged on the board **301,** the board **301** and the rib **304b** become substantially parallel to each other. In order to regulate the direction and angle of insertion of the external terminal device **200,** the guide portion **305** of the second member **403** is arranged to define the predetermined angle described above with respect to the rib **304b.**

The second member **403** also has connecting portions **404.**

The end of the connecting portions **404** is made of an elastically deformable material (such as resin or metal). By fitting the end of the connecting portions **404** into the holes **306** of the board **301,** the second member **403** gets mounted onto the board **301.** In this manner, the connecting slot **103** can be mounted onto the board **301** stepwise.

More Specifically, by performing a first process step of soldering, the first member **402** gets mounted onto the board **301.**

Next, a second process step is performed manually. In this second process step, the connecting portions **404** are fitted into the holes of the board **301.** In this manner, the second member **403** can get mounted onto the board **301.** If this procedure is followed, circuit components that have been mounted on the board **301** and under the second member **403** can be checked out more easily with the eyes in a testing process step between the first and second process steps while the display device **100** is being assembled. In addition, since the worker can easily remove the second member **403** from the board **301,** the circuit components mounted under the second member **403** can be repaired more easily.

FIGS. **7(b)**, **7(c)**, **7(d)** and **7(e)** are respectively a left side view, a top view, a right side view, and a bottom view of the second member **403.** As shown in FIG. **7(e)****,** the bottom of the connecting slot **103** has a shape to cover the board **301.** In that case, even if the external terminal device **200** has not been inserted into the display device **100** yet, the board **301** is not exposed directly through the connecting slot **103.** Thus, the chances that the user of this display device **100** will happen to touch the board **301** by mistake can be reduced.

According to the embodiment described above, there is no need to create a space for housing the external terminal device on the board **301.** Since the space that is ordinarily secured for the external terminal device **200** can be eliminated from the board **301,** the design process can get done more easily. In addition, since the required area of the board **301** can be reduced, the cost can be cut down, too.

### INDUSTRIAL APPLICABILITY

A display device according to the present invention can be used effectively as a device to which an external terminal device for use to remove a viewing control and for other purposes is attachable.

### REFERENCE SIGNS LIST

- **100**: display device
- **101**: back cover
- **102**: group of terminals
- **103**: connecting slot
- **104**: back cover's first plane
- **105**: back cover's second plane
- **106**: step portion
- **110**: display panel
- **200**: external terminal
- **301**: board
- **303**: connecting slot's terminal
- **304a, 304b**: rib
- **305**: guide
- **402**: connecting slot's first member
- **403**: connecting slot's second member

## Claims

1. A display device comprising:
a display panel;
a board;
a back cover which covers the board at least partially and which has an opening; and
a slot structure which is arranged inside the opening and into which an external terminal device is inserted,
wherein the slot structure includes a guide which holds the external terminal device inserted so that the external terminal device defines a predetermined angle with respect to the board and a terminal which electrically connects the external terminal device to the board.

2. The display device of claim 1, wherein the guide regulates the angle of insertion of the external terminal device so that the external terminal device is inserted at the predetermined angle with respect to the board.

3. The display device of claim 1 or 2, wherein if the guide has a length of 40 mm or more, the guide holds the external terminal device so that the external terminal device defines an angle of 5 to 9 degrees with respect to the board.

4. The display device of one of claims 1 to 3, wherein the bottom surface of the slot structure partially covers the board.

5. The display device of claim 4, wherein the slot structure has a box shape which is formed by the bottom surface of the slot structure and side surfaces that cover the slot structure entirely except an insertion slot into which the external terminal device is inserted.

6. The display device of one of claims 1 to 5, wherein the slot structure covers the periphery of the opening at least partially.

7. The display device of one of claims 1 to 6, wherein the slot structure is comprised of a plurality of members including a first member with the terminal and a second member with the guide.

8. The display device of claim 7, wherein the second member has connecting portions for mounting the second member onto the board.

9. The display device of claim 8, wherein an end of the connecting portions is made of an elastically deformable material, and
the second member is mounted onto the board by elastically deforming the respective ends of the connecting portions and fitting the ends into holes or notches that have been cut through the board.

10. The display device of one of claims 1 to 3, wherein the back cover has a first plane and a second plane which is arranged so as to be raised with respect to the first plane,
the opening has been cut through the second plane, and
when the guide holds the external terminal device, the external terminal device is held so as to be housed within the second plane.

11. The display device of claim 10, wherein a terminal receiving a signal from an external device is arranged in a step portion which is located between the first and second planes.
